# EUROPEAN PATENT APPLICATION

(11) **EP 4 478 564 A1**
(43) Date of publication of application: **18.12.2024**
(21) Application number: 23752940.9
(22) Date of filing: 09.02.2023
(51) Int. Cl.: H01S 5/0237, H01L 33/62

(54) **LIGHT-EMITTING DEVICE PRODUCTION METHOD AND PRODUCTION DEVICE, AND LASER ELEMENT SUBSTRATE**

(30) Priority: 10.02.2022 JP 2022019835
(71) Applicant: Kyocera Corporation, Kyoto-shi, Kyoto 612-8501 (JP)
(72) Inventor: KAWAGUCHI, Yoshinobu, Kyoto-shi, Kyoto 612-8501 (JP); MURAKAWA, Kentaro, Kyoto-shi, Kyoto 612-8501 (JP); KAMIKAWA, Takeshi, Kyoto-shi, Kyoto 612-8501 (JP)
(74) Representative: Viering, Jentschura & Partner mbB Patent- und Rechtsanwälte
(86) International application number: PCT/JP2023/004376
(87) International publication number: WO 2023/153476

(57) **Abstract**

A manufacturing method for a light-emitting device, the manufacturing method including: preparing a first substrate provided with a plurality of light-emitting bodies; preparing a second substrate including a first bonding portion having conductivity, a first pad portion electrically connected to the first bonding portion, and a first solder regulating portion located between the first bonding portion and the first pad portion, the second substrate including a solder formed on the first bonding portion; bonding a first object selected from the plurality of light-emitting bodies to the second substrate with the solder; and transferring the first object to the second substrate by separating the first substrate and the second substrate from each other.

## Description

### TECHNICAL FIELD

The present disclosure relates to a manufacturing method and a manufacturing apparatus for a light-emitting device, and a laser element substrate.

### BACKGROUND OF INVENTION

Patent Document 1 discloses a technique of transferring a semiconductor element to a circuit board.

### CITATION LIST

### PATENT LITERATURE

Patent Document 1: JP 2019-220666 A

### SUMMARY

A manufacturing method for a light-emitting device according to the present disclosure includes: preparing a first substrate provided with a plurality of light-emitting bodies; preparing a second substrate including a first bonding portion having conductivity, a first pad portion electrically connected to the first bonding portion, and a first solder regulating portion located between the first bonding portion and the first pad portion, the second substrate including a solder formed on the first bonding portion; bonding a first object selected from the plurality of light-emitting bodies to the second substrate with the solder; and transferring the first object to the second substrate by separating the first substrate and the second substrate from each other.

### BRIEF DESCRIPTION OF THE DRAWINGS

FIG. 1 is a flowchart illustrating a manufacturing method for a light-emitting device according to the present embodiment.
FIG. 2 is a cross-sectional view illustrating the manufacturing method for a light-emitting device.
FIG. 3 is a cross-sectional view illustrating the manufacturing method for a light-emitting device.
FIG. 4 is a plan view illustrating a configuration of a second substrate in FIGs. 1 to 3.
FIG. 5 is a plan view illustrating another configuration of the second substrate.
FIG. 6 is a plan view illustrating another configuration of the second substrate.
FIG. 7 is a plan view illustrating another configuration of the second substrate.
FIG. 8 is a cross-sectional view illustrating another manufacturing method for a light-emitting device.
FIG. 9 is a plan view illustrating the second substrate in FIG. 8.
FIG. 10 is a plan view illustrating another configuration of the second substrate.
FIG. 11 is a cross-sectional view illustrating a bonded state of the second substrate and a light-emitting body.
FIG. 12 is a cross-sectional view illustrating a bonded state of the second substrate and the light-emitting body.
FIG. 13 is a block diagram illustrating a configuration of a manufacturing apparatus for a light-emitting device according to the present embodiment.
FIG. 14 is a perspective view illustrating a configuration of a laser element substrate.
FIG. 15 is a perspective view illustrating another configuration of the laser element substrate.
FIG. 16 is a perspective view illustrating a configuration of a laser element.
FIG. 17 is a perspective view illustrating a configuration of a laser module.
FIG. 18 is a cross-sectional view illustrating a manufacturing method for a first substrate.
FIG. 19 is a cross-sectional view illustrating a configuration example of a base substrate.
FIG. 20 is a cross-sectional view illustrating a configuration example of a first substrate.

### DESCRIPTION OF EMBODIMENTS

### Selective Transfer

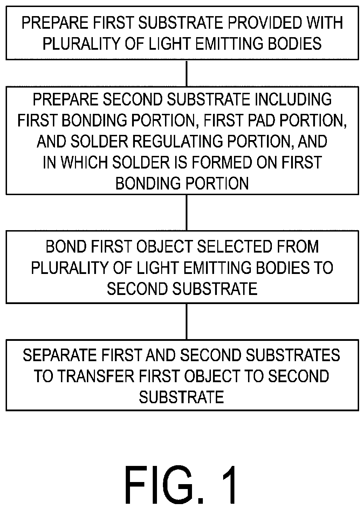

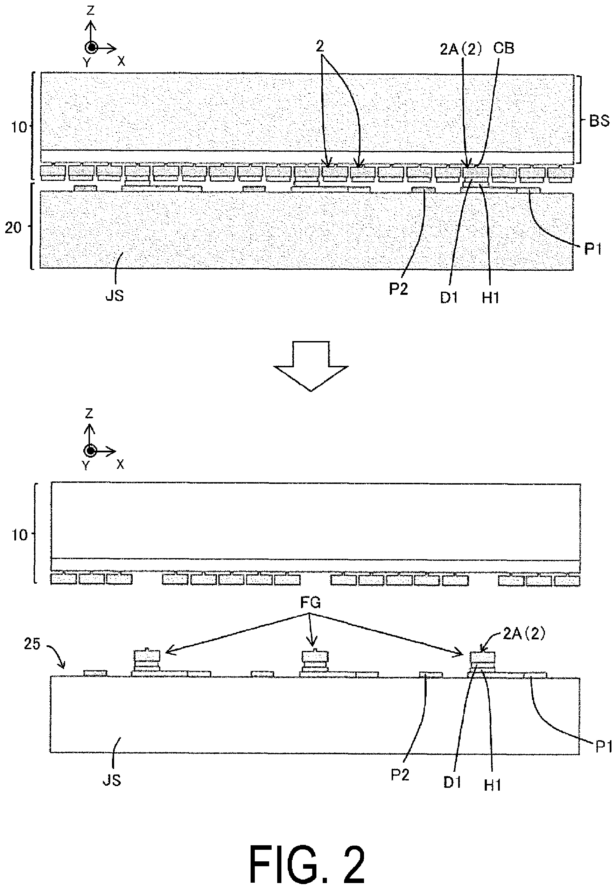

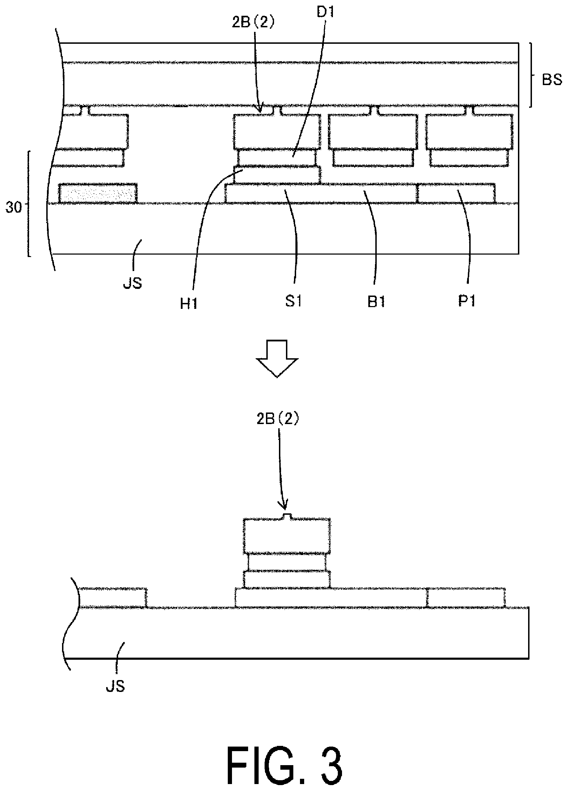

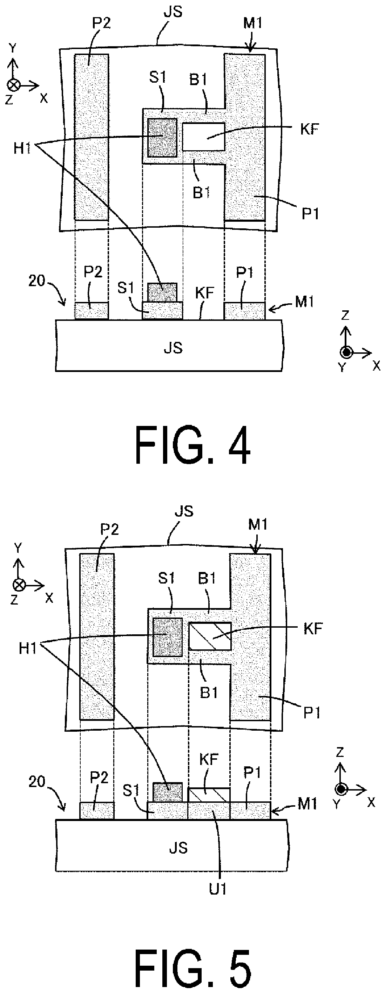

FIG. 1 is a flowchart illustrating a manufacturing method for a light-emitting device according to the present embodiment. FIGs. 2 and 3 are cross-sectional views illustrating the manufacturing method for a light-emitting device. FIG. 4 is a plan view illustrating a configuration of a second substrate in FIGs. 1 to 3. As illustrated in FIGs. 1 to 4, the manufacturing method for a light-emitting device according to the present embodiment includes: preparing a first substrate 10 provided with a plurality of light-emitting bodies 2; preparing a second substrate 20 including a first bonding portion S1 having conductivity, a first pad portion P1 electrically connected to the first bonding portion S1, and a first solder regulating portion KF located between the first bonding portion S1 and the first pad portion P1, the second substrate 20 including a solder H1 formed on the first bonding portion S1; bonding a first object 2A selected from the plurality of light-emitting bodies 2 to the second substrate 20; and transferring the first object 2A to the second substrate 20 by separating the first substrate 10 and the second substrate 20 from each other. The first bonding portion S1 including the solder H1 formed on the upper surface is used for bonding (solder bonding) to the light-emitting body 2, and the conductive first pad portion P1 is used for connection to the outside (e.g., wire bonding).

A light-emitting element substrate 25 (light-emitting device) can be obtained by selectively transferring a first object group FG, including the first object 2A, to the second substrate 20. The light-emitting element substrate 25 may be divided into a plurality of pieces (to be described later), or the light-emitting element substrate 25 may be separated into individual pieces to obtain laser elements or the like (light-emitting devices).

In the present embodiment, the flow and spread of the solder H1 melted on the first bonding portion S1 is regulated by the first solder regulating portion KF. This reduces the possibility that the solder H1 flows and spreads to a portion other than the first object 2A (the target of the selective transfer) to cause a selective transfer failure. In addition, the possibility that the melted solder H1 flows and spreads to a first pad P1 and causes a problem in a subsequent process (e.g., a wire bonding failure occurs) can be reduced.

Each of the light-emitting bodies 2 may include the first electrode D1, and the first substrate 10 and second substrate 20 may be brought close to each other while at least one of the first substrate 10 and second substrate 20 is heated to bring the melted solder H1 into contact with the first electrode D1 of the first object 2A selected from the plurality of light-emitting bodies 2.

The plurality of light-emitting bodies 2 may be arranged in the X direction, and the first bonding portion S1 and the first pad portion P1 may be arranged in the X direction. The interval between the adjacent light-emitting bodies 2 may be smaller than the size of the first pad portion P1 in the X direction, and may be smaller than the size of the first bonding portion S1 in the X direction.

The first solder regulating portion KF may be lower in wettability of the solder H1 than the first bonding portion S1. The first solder regulating portion KF may be recessed from the first bonding portion S1. Each of the first bonding portion S1 and the first pad portion may be a single layer body or a stacked body containing at least one of gold (Au), chromium (Cr), or platinum (Pt). The first solder regulating portion KF may be non-conductive.

The first substrate 10 includes a base substrate BS (crystal growth substrate), and the second substrate 20 includes an underlying substrate JS. The underlying substrate JS may be exposed at the first solder regulating portion KF, and in this case, the wettability of the solder H1 may be lower at the exposed underlying substrate front surface (first solder regulating portion KF) than in the first bonding portion S1. As the underlying substrate JS, for example, a silicon substrate or a silicon carbide (SiC) substrate can be used. In the single-crystal silicon or silicon carbide, wettability of the solder H1 is lower than wettability of the metallic first bonding portion S1.

In a case where a silicon substrate (main substrate) is included in the base substrate BS, the silicon substrate may be used as the underlying substrate JS, and in a case where a silicon carbide substrate is included in the base substrate BS, the silicon carbide substrate may be used as the underlying substrate JS. When the materials of the main substrate and the underlying substrate JS included in the base substrate BS are the same (that is, the thermal expansion coefficients are the same), the first object 2A and the second substrate 20 can be favorably bonded (selectively transferred).

When a direction orthogonal to the X direction is defined as a Y direction, the second substrate 20 may be provided with two conductive bridging portions B1 facing each other in the Y direction, sandwiching the first solder regulating portion KF, and the first bonding portion S1 and the first pad portion P1 may be electrically connected to each other via the two bridging portions B1. The sum of the size of the first bonding portion S1 in the X direction and the size of the first pad portion P1 in the X direction may be larger than the size of the light-emitting body 2 in the X direction. The first electrode D1 may be an anode.

The first pad portion P1, the first bonding portion S1, and the bridging portion B1 may be made of a metal pattern M1 formed in the same step, and the first solder regulating portion KF may be an opening of the metal pattern. That is, the first pad portion P1, the first bonding portion S1, and the bridging portions B1 and B2 may be formed in the same layer and of the same material. The metal pattern M1 may be a stacked pattern in which Cr, Pt, and Au are stacked in this order.

The size of the first pad portion P1 in the Y direction may be larger than that of the first bonding portion S1. The size of the solder H1 in the Y direction may be larger than that of the first solder regulating portion KF. The bridging portion B1 may be smaller in size in the Y direction than the first bonding portion S1 and the first pad portion P1. The second substrate 20 may include a second pad portion P2 electrically insulated from the first pad portion P1.

After melting the solder H1 by heating the second substrate 20, the solder H1 may be solidified by lowering the temperature of the second substrate 20. A connection portion CB between the base substrate BS and the light-emitting body 2 may be broken by an external force applied after the solder H1 is solidified, or may be broken by itself when the solder H1 is solidified.

As illustrated in FIG. 3, after the transfer of the first object 2A, a second object 2B selected from the plurality of light-emitting bodies 2 remaining on the first substrate 10 may be transferred to a third substrate 30. By repeating this operation, all the light-emitting bodies 2 can be transferred to a plurality of the second substrates.

FIG. 5 is a plan view illustrating another configuration of the second substrate. As illustrated in FIG. 5, the first solder regulating portion KF may protrude from the first bonding portion S1. The first solder regulating portion KF may include a dielectric material. The first bonding portion S1, the bridging portions B1 and B2, the base portion U1 under the first solder regulating portion, and the first pad portion P1 may be made of the metal pattern M1 formed in the same step, or the first solder regulating portion KF may be made of a dielectric formed over the base portion U1 and having a wettability lower than a wettability of the metal pattern M1. The dielectric may be an insulating film such as a silicon nitride film or a silicon oxide film.

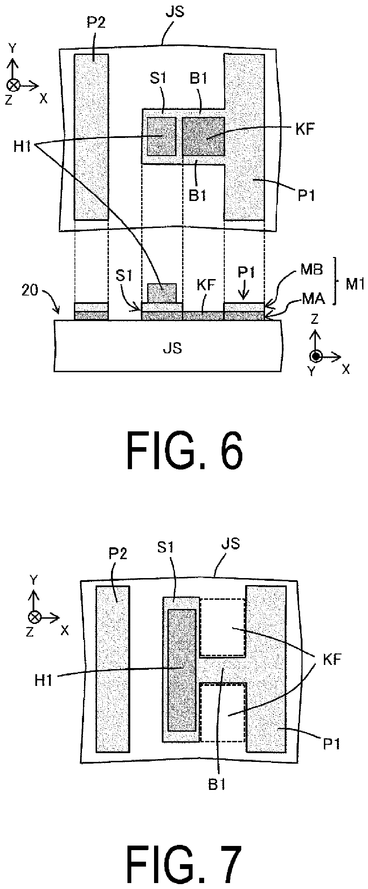

FIG. 6 is a plan view illustrating another configuration of the second substrate. As illustrated in FIG. 6, the first solder regulating portion KF may be recessed from the first bonding portion S1. The first solder regulating portion KF is conductive and may be electrically connected to the first bonding portion S1. The first pad portion P1, the first bonding portion S1, and the bridging portions B1 and B2 may be made of the metal pattern M1 (stacked pattern of a lower layer portion MA and an upper layer portion MB) formed in the same step, and the first solder regulating portion KF may be an opening (exposed lower layer portion MA) of the upper layer portion MB. The lower layer portion MA may contain Pt, and the upper layer portion MB may contain Au. The solder H1 may contain gold (Au), the front surface (upper layer portion MB) of the first bonding portion S1 may be made of gold (Au), and the first solder regulating portion KF (exposed lower layer portion MA) may be made of platinum (Pt). Pt has a wettability of the solder H1 lower than a wettability of Au.

FIG. 7 is a plan view illustrating another configuration of the second substrate. As illustrated in FIG. 7, in the second substrate 20, one bridging portion B1 may be located between the first bonding portion S1 and the first pad portion P1 arranged in the X direction, and the first solder regulating portions KF may be formed on both sides of the bridging portion B1 in the Y direction. That is, the two first solder regulating portions KF arranged in the Y direction may be formed between the first bonding portion S1 and the first pad portion P1 arranged in the X direction, and the bridging portion B1 (electrically connecting the first bonding portion S1 and the first pad portion P1) may be provided between two first solder regulating portions KF. The first solder regulating portion KF may be a semiconductor, a conductor, or a dielectric as long as the wettability thereof is lower than that of the first bonding portion S1.

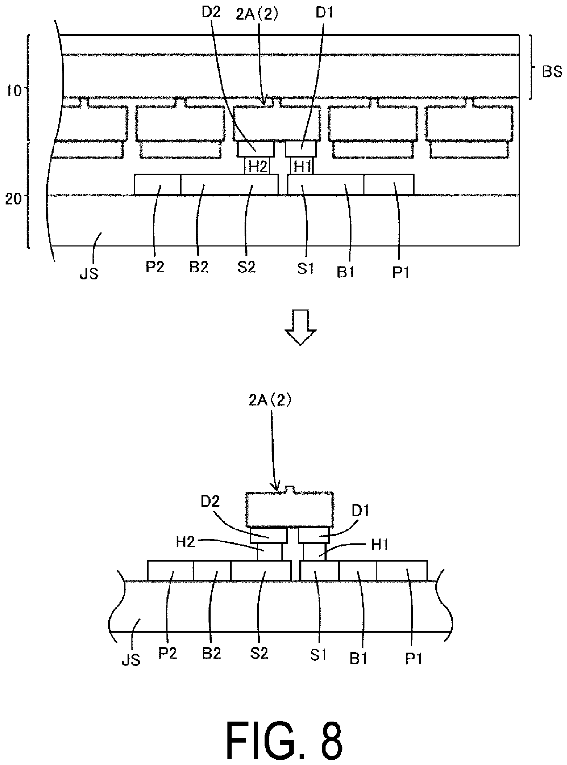

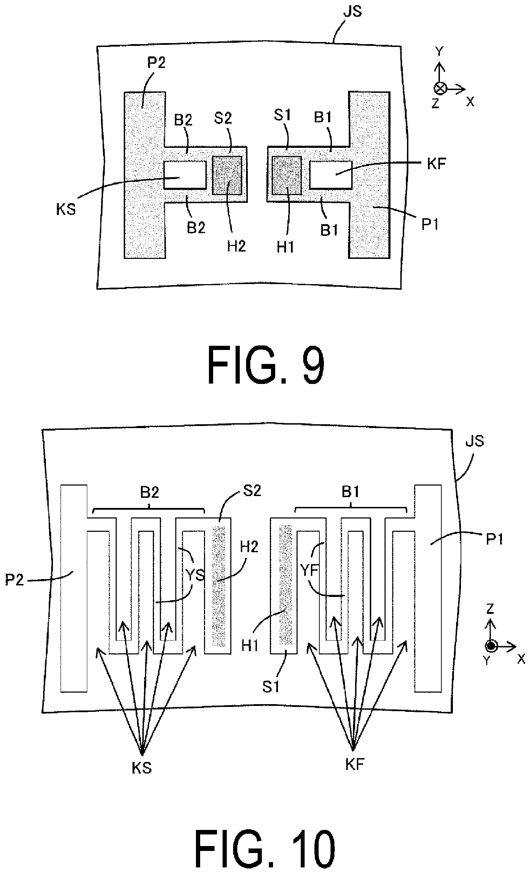

FIG. 8 is a cross-sectional view illustrating another manufacturing method for a light-emitting device. FIG. 9 is a plan view illustrating the second substrate in FIG. 8. As illustrated in FIGs. 8 and 9, the light-emitting body 2 may include a second electrode D2, and the second substrate 20 may include the conductive first bonding portion S1, the first pad portion P1 electrically connected to the first bonding portion S1, one or more first solder regulating portions KF located between the first bonding portion S1 and the first pad portion P1, the conductive second bonding portion S2, the second pad portion P2 electrically connected to the second bonding portion S2, and one or more second solder regulating portions KS located between the second bonding portion S2 and the second pad portion P2. The solder H1 may be formed on the first bonding portion S1, and the solder H2 may be formed on the second bonding portion S2.

After the melted solder H1 on the first bonding portion S1 is brought into contact with the first electrode D1 of the first object 2A and the melted solder H2 on the second bonding portion S2 is brought into contact with the second electrode D2 of the first object 2A, the first substrate 10 and second substrate 20 may be separated to transfer the first object 2A to the second substrate 20. The first bonding portion S1 and the first pad portion P1 may be electrically connected to each other via the bridging portion B1, and the second bonding portion S2 and the second pad portion P2 may be electrically connected to each other via the bridging portion B2. The first electrode D1 may be an anode, and the second electrode D2 may be a cathode.

FIG. 10 is a plan view illustrating another configuration of the second substrate. As illustrated in FIG. 10, the first bonding portion S1 and the first pad portion P1 may be electrically connected to each other via the bridging portion B1 having a bent shape, and the second bonding portion S2 and the second pad portion P2 may be electrically connected to each other via the bridging portion B2 having a bent shape. The bridging portion B1 may have a shape in which bending is repeated a plurality of times, the bridging portion B1 may include a plurality of extending portions YF extending in the Y direction, and the first solder regulating portion KF may be formed between the first bonding portion S1 and the extending portion YF and between adjacent extending portions YF. The bridging portion B2 may have a shape in which bending is repeated a plurality of times, the bridging portion B2 may include a plurality of extending portions YS extending in the Y direction, and the second solder regulating portion KS may be formed between the second bonding portion S2 and the extending portion YS and between adjacent extending portions YS.

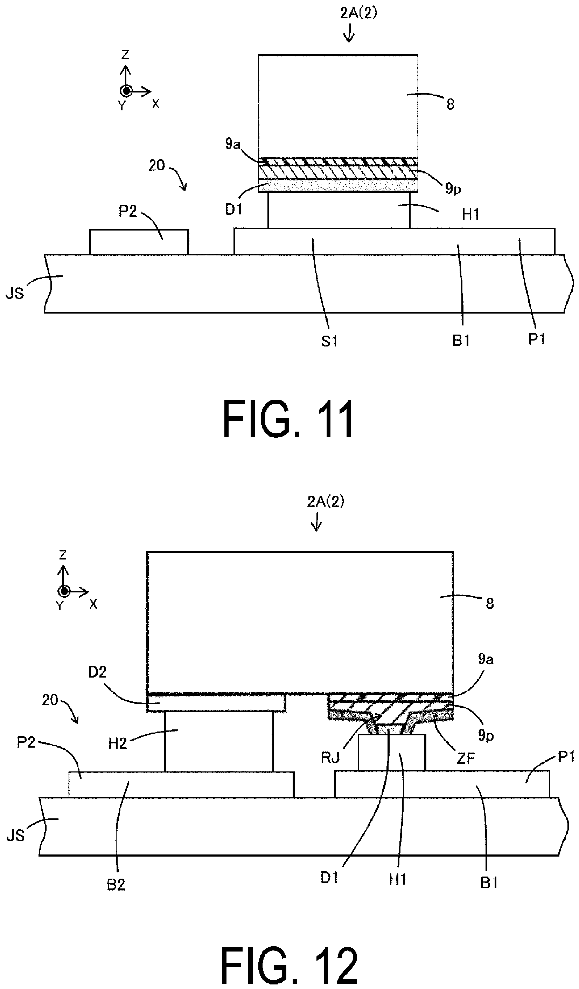

FIG. 11 is a cross-sectional view illustrating a bonding state of the second substrate and the light-emitting body. In FIG. 11, the first electrode D1 of the light-emitting body 2 is bonded to the first pad P1 on the underlying substrate JS via the solder H1. The light-emitting body 2 may include a base semiconductor portion 8 including a nitride semiconductor (e.g., GaN-based semiconductor), an n-type semiconductor portion 9n, an active portion 9a, a p-type semiconductor portion 9p, and the first electrode D1 (anode) in this order. The base semiconductor portion 8 may be of the n-type. The light-emitting body 2 may be a light-emitting diode (LED). A cathode (not illustrated) may be formed on the back surface of the base semiconductor portion 8 after the light-emitting body 2 is transferred, and the cathode may be electrically connected to the second pad P2.

FIG. 12 is a cross-sectional view illustrating a bonding state between the second substrate and the light-emitting body. In FIG. 12, the first electrode D1 (anode) of the light-emitting body 2 is bonded to the first pad P1 on the underlying substrate JS via the solder H1, and the second electrode D2 (cathode) of the light-emitting body 2 is bonded to the second pad P2 on the underlying substrate JS via the solder H2. The light-emitting body 2 may include the base semiconductor portion 8 including a nitride semiconductor (e.g., GaN-based semiconductor), the n-type semiconductor portion 9n, the active portion 9a, the p-type semiconductor portion 9p including a ridge RJ, and the first electrode D1 in this order, and the second electrode D2 may be formed on the base semiconductor portion 8. An insulating film ZF may be provided around the ridge RJ. The base semiconductor portion 8 may be of the n-type. The light-emitting body 2 may be an edge-emitting semiconductor laser body (chip).

In FIG. 12, the first object 2A may be transferred to the second substrate 20 so that the Y direction orthogonal to the X direction in which the light-emitting bodies 2 are arranged and the resonator length direction of the first object 2A (light-emitting body 2) coincide with each other.

### Manufacturing Apparatus

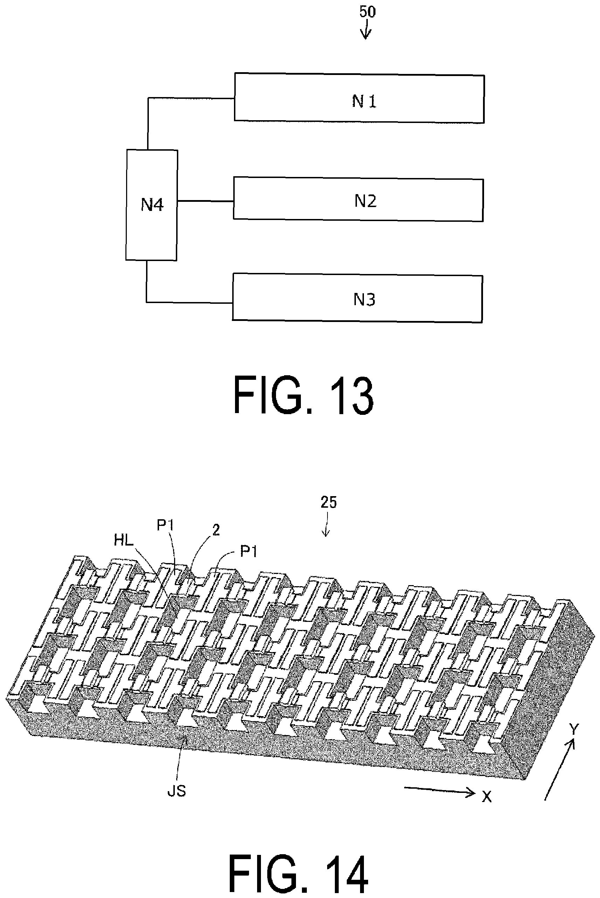

FIG. 13 is a block diagram illustrating a configuration of a manufacturing apparatus for a light-emitting device according to the present embodiment. The manufacturing apparatus 50 for a light-emitting device includes: an apparatus N1 for preparing the first substrate 10 provided with a plurality of light-emitting bodies 2; an apparatus N2 for preparing the second substrate 20 including the conductive first bonding portion S1, the first pad portion P1 electrically connected to the first bonding portion S1, and the first solder regulating portion KF located between the first bonding portion S1 and the first pad portion P1, the second substrate 20 including the solder H1 formed on the first bonding portion S1; an apparatus N3 for transferring the first object 2A selected from the plurality of light-emitting bodies 2 to the second substrate 20 by separating the first substrate 10 and the second substrate 20 after bonding the first object 2A to the second substrate 20; and an apparatus N4 that controls the apparatuses N1 to N3.

### Laser Element Substrate

FIG. 14 is a perspective view illustrating the configuration of the laser element substrate. In a case where each of the plurality of light-emitting bodies 2 of the first substrate 20 is a semiconductor laser body (chip), the light-emitting element substrate 25 to which the plurality of light-emitting bodies 2 are transferred can be referred to as a laser element substrate 25 (light-emitting device). In FIG. 14, a recessed portion HL may be formed in the underlying substrate JS, and the light-emitting body 2 (first object) may be transferred to the second substrate 20 such that a light-exit end of the light-emitting body 2 (first object) is located on the recessed portion HL.

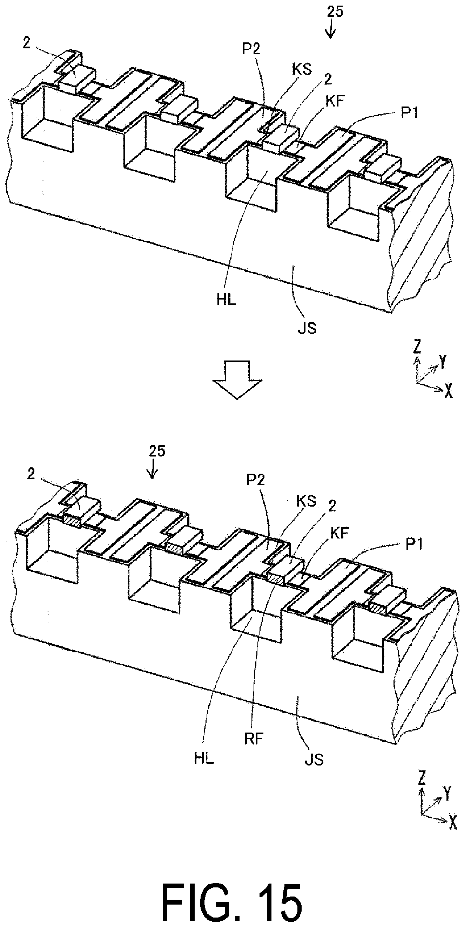

FIG. 15 is a perspective view illustrating another configuration of the laser element substrate. The two dimensional arrangement type laser element substrate 25 in FIG. 14 may be divided into one dimensional arrangement type laser element substrate 25 as illustrated in FIG. 15. As illustrated in FIG. 15, in the one dimensionally arranged laser element substrate 25, a step of forming a reflective film RF on the cavity facet of each semiconductor laser body 2 (so-called facet coating) may be performed.

The laser element substrate 25 in FIG. 15 includes the underlying substrate JS and the plurality of laser diode bodies 2, where the conductive first bonding portion S1, the first pad portion P1 electrically connected to the first bonding portion S1, and the first solder regulating portion KF located between the first bonding portion S1 and the first pad portion P1 are located on the underlying substrate JS, the first bonding portion S1 and the first pad P1 are arranged in the X direction (first direction), each laser diode body 2 (laser diode chip 2) is soldered to the first bonding portion S1 such that the resonator length direction is orthogonal to the X direction, and the underlying substrate JS has a recessed portion (hollow portion) HL located below the light-exit end of each semiconductor laser body 2.

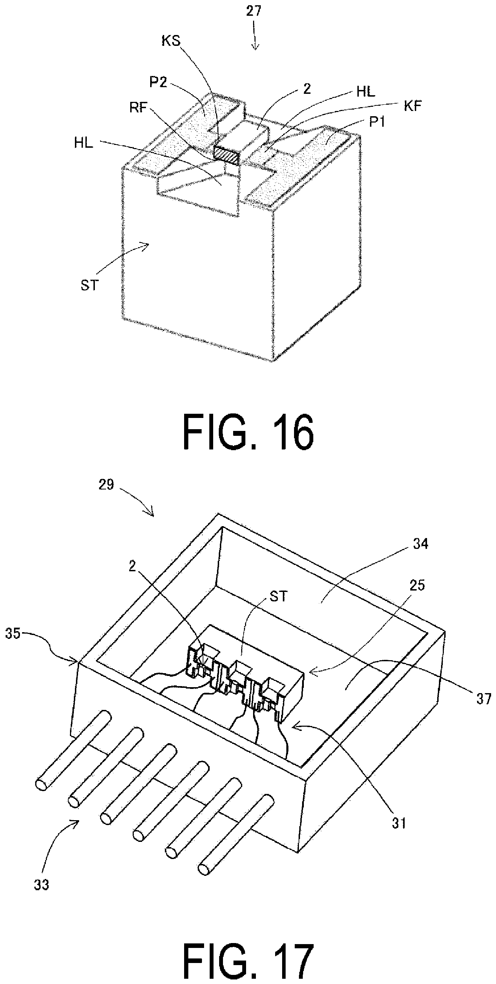

FIG. 16 is a perspective view illustrating a configuration of a laser element. A laser element 27 (light-emitting device) in which the semiconductor laser body 2 is mounted on a support ST as illustrated in FIG. 16 can be formed by separating the one dimensional arrangement type laser element substrate 25 in FIG. 15 into individual pieces.

FIG. 17 is a perspective view illustrating a configuration of a laser module. A laser module 29 (light-emitting device) in FIG. 17 is a surface mount technology type package and includes a housing 35 and the laser element substrate 25. The laser element substrate 25 includes the plurality of light-emitting bodies 2 (semiconductor laser chips), and is provided such that a side surface (a surface parallel to the resonance end surface) of the support ST faces the bottom surface 31 of the housing 35. Therefore, the emission surface (the resonance end surface on the emission side) of each light-emitting body 2 faces a top surface 34 (transparent plate) of the housing 35, and the laser light is emitted from the top surface 34 of the housing 35. The light-emitting body 2 is connected to an external connection pin 33 via a wire 31.

In the related art, a chip on submount (CoS) needs to be manufactured by individually die-bonding the laser chip to the submount, but in FIG. 17, since the support ST functions as the submount and the light-emitting body 2 (semiconductor laser chip) itself has a CoS structure, die-bonding to the submount is unnecessary. Thus, the problem of difficulty in handling when the resonance length (resonator length) is short or the chip width is narrow can be solved. The light-emitting body 2 includes the first pad portion P1 and second pad portion P2 of a size necessary for bonding wire onto the support ST, and the first pad portion P1 and second pad portion P2 are electrically connected to the first electrode D1 and second electrode D2 of the light-emitting body 2 (semiconductor laser chip). With this configuration, it is sufficient to electrically connect the external connection pin 33 of the package to the first pad portion P1 and second pad portion P2 with the wire 31.

### Manufacturing Method for First Substrate

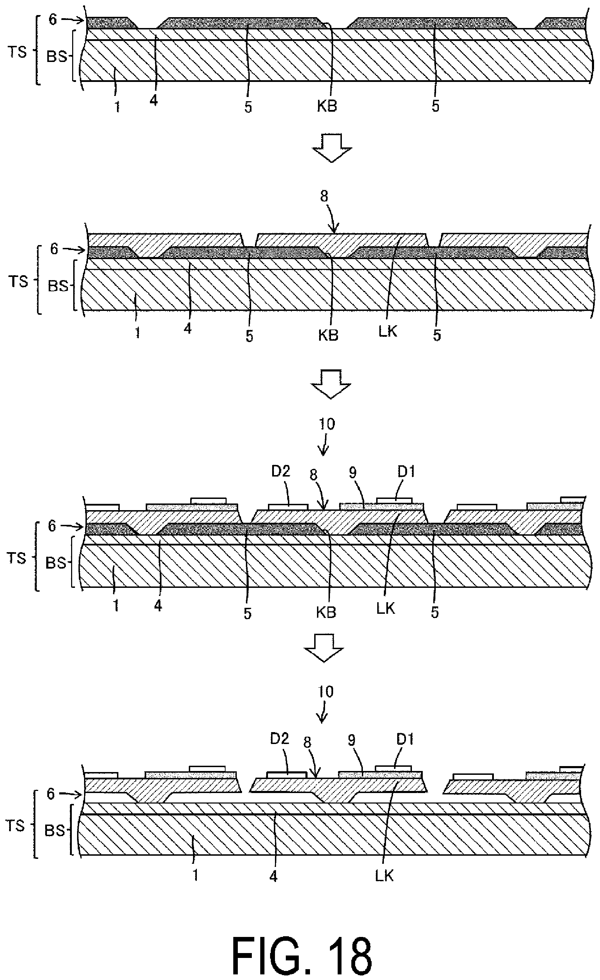

FIG. 18 is a cross-sectional view illustrating the manufacturing method for the first substrate. In FIG. 18, an underlying portion 4 including a nitride semiconductor is formed on a main substrate 1, and a mask pattern 6 including a plurality of stripe-shaped mask portions 5 is provided on the underlying portion 4. The mask portion 5 is made of, for example, a silicon nitride film having a thickness 100 nm and a thickness of 52 µm, and has a longitudinal direction in the X direction. The pitch of the stripes of the mask portion 5 is 55 µm, for example.

A resist stripe pattern is formed by a photolithography technique on the base substrate BS on which the nitride semiconductor film is formed as the underlying portion 4. Next, a silicon nitride film having a thickness of, for example, 100 nm is formed on the entire surface by a sputtering method. Next, the silicon nitride film is patterned by a lift-off method to form a mask pattern 6 (stripe pattern). Next, the base semiconductor portion 8 is grown on the mask pattern 6 by metal organic chemical vapor deposition (MOCVD) using, for example, trimethylgallium (TMG) and ammonia (NH₃) (ELO method).

The base semiconductor portion 8 contains a nitride semiconductor as a main material. The nitride semiconductor may be expressed by, for example, AlₓGa_{y}In_{z}N (0 ≤ x ≤ 1; 0 ≤ y ≤ 1; 0 ≤ z ≤ 1; x + y + z = 1). Specific examples of the nitride semiconductor may include a GaN-based semiconductor, aluminum nitride (AlN), indium aluminum nitride (InAlN), and indium nitride (InN). The GaN-based semiconductor is a semiconductor containing gallium atoms (Ga) and nitrogen atoms (N). Typical examples of the GaN-based semiconductor may include GaN, AlGaN, AlGaInN, and InGaN. The base substrate BS and the mask 6 may be collectively referred to as a template substrate TS.

In FIG. 18, an initial growth portion is formed above the underlying portion 4 (including, for example, a seed portion) exposed to an opening portion KB of the mask 6. The initial growth portion serves as a starting point of lateral growth of the base semiconductor portion 8. The initial growth portion can be formed to have a width of, for example, 30 nm to 1000 nm, 50 nm to 400 nm, or 70 nm to 350 nm. By performing the lateral growth from the state where the initial growth portion slightly protrudes from the mask portion 5, the growth of the base semiconductor portion 8 in the c-axis direction (thickness direction) can be suppressed, and the base semiconductor portion 8 can be laterally grown at a high speed and with high crystallinity. This makes it possible to form a thin, wide, and low-defect base semiconductor portion 8 (a crystal of a nitride semiconductor such as GaN) at low cost.

The base semiconductor portions 8 laterally grown in opposite directions from the two adjacent opening portions KB do not contact (meet) each other on the mask portion 5 and have a gap (spacing) GP, so that the stress in cross section of the base semiconductor portion 8 can be reduced. As a result, cracks and defects (dislocations) generated in the base semiconductor portion 8 can be reduced. This effect is particularly effective when the main substrate 1 is a heterogeneous substrate (a substrate having a lattice constant different from that of the base semiconductor portion 8). A width of the gap GP can be, for example, 10 µm or less, 5 µm or less, 3 µm or less, or 2 µm or less.
In the base semiconductor portion 8, a portion located on the initial growth portion serves as a dislocation succession portion having many threading dislocations, and a portion (wing portion) on the mask portion 5 serves as a low-defect portion LK having a threading dislocation density of 1/10 or less as compared with the dislocation succession portion. The threading dislocation is a dislocation (defect) extending in the base semiconductor portion 8 in the c-axis direction (<0001> direction). The threading dislocation density of the low-defect portion LK can be set to, for example, 5 × 10⁶ [/cm²] or less.

On the base semiconductor portion 8, for example, a compound semiconductor portion 9 including an active portion and a p-type semiconductor portion, and the first electrode D1 and the second electrode D2 can be formed. When the active portion (active layer) is formed, the light-emitting portion can be disposed above the low-defect portion LK (so as to overlap the low-defect portion LK in a plan view). A plurality of light-emitting bodies may be formed by dividing the base semiconductor portion 8 and the compound semiconductor portion 9 on the template substrate TS (e.g., division is performed so that the cross section is m-plane). The mask 6 may be removed before the transfer of the light-emitting bodies.

A ratio of the size in the a-axis direction to the thickness of the low-defect portion LK can be set to, for example, 2.0 or more. Using the approach in FIG. 18, this size ratio can be 1.5 or more, 2.0 or more, 4.0 or more, 5.0 or more, 7.0 or more, or 10.0 or more. It is known that when the size ratio is set to 1.5 or more, division of the base semiconductor portion 8 (e.g., division in which the cross section is an m-plane) is facilitated in a subsequent step. In addition, the stress in cross section of the base semiconductor portion 8 is reduced, and the warpage of the second substrate 20 is reduced.

An aspect ratio (a ratio of the size in the X direction to the height) of the base semiconductor portion 8 may be 3.5 or more, 5.0 or more, 6.0 or more, 8.0 or more, 10 or more, 15 or more, 20 or more, 30 or more, or 50 or more. By using the method in FIG. 18, the ratio of the size of the base semiconductor portion 8 in the X direction to the width of the opening portion KB can be set to 3.5 or more, 5.0 or more, 6.0 or more, 8.0 or more, 10 or more, 15 or more, 20 or more, 30 or more, or 50 or more, and the ratio of the low-defect portion LK can be increased.

The base semiconductor portion 8 (including the initial growth portion) illustrated in FIG. 18 may be a nitride semiconductor crystal (e.g., a GaN crystal, an AlGaN crystal, an InGaN crystal, or an InAlGaN crystal).

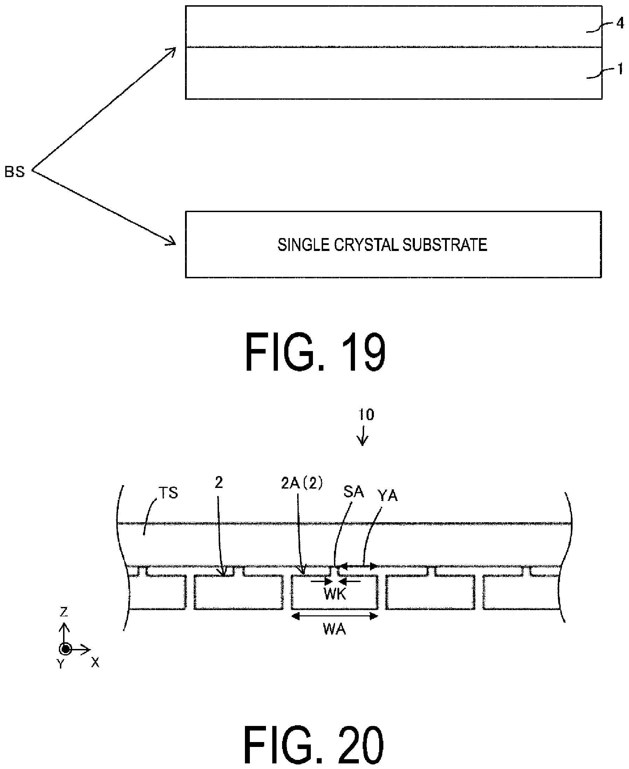

FIG. 19 is a cross-sectional view illustrating a structure example of a base substrate. The base substrate BS may include the main substrate 1 and the underlying portion 4 on the main substrate 1. The underlying portion 4 may include a GaN-based semiconductor. The underlying portion 4 may include at least one of a seed portion and a buffer portion. As the seed portion, a GaN-based semiconductor can be used. As the buffer portion, a GaN-based semiconductor, AlN, SiC, or the like can be used. The base substrate BS may be made of a self-standing single crystal substrate (e.g., a wafer cut out from a bulk crystal) such as GaN or SiC, and the mask 6 may be disposed on the single crystal substrate.

FIG. 20 is a cross-sectional view illustrating a configuration example of the first substrate. As illustrated in FIG. 20, the first substrate 10 may include a template substrate TS including a seed region SA and a growth suppression region YA, and the first object 2A may be crystalline-bonded to the seed region SA and may overlap the growth suppression region YA in a plan view (when viewed in a line of sight parallel to the Z-direction). The seed region SA may be made of a nitride semiconductor such as AlN. The growth suppression region YA is made of any material that suppresses the vertical growth (e.g., growth in the c-axis direction) of the base semiconductor portion 8 (nitride semiconductor portion). Examples of the material include an amorphous material such as silicon nitride or silicon oxide, a semiconductor material such as SiC, a polycrystalline material, and a metal material. When the arrangement direction X (first direction) of the plurality of light-emitting bodies 2 is defined as the widthwise direction, a combined width WK of the first object 2A and the seed region SA may be 1/5 or less, 1/7 or less, or 1/10 or less of the width WA of the first object 2A.

### Supplementary Note

The foregoing disclosure has been presented for purposes of illustration and description, and not limitation. It is noted that many variations will be apparent to those skilled in the art based on these illustrations and descriptions, and these variations are included in the embodiments.

### REFERENCE SIGNS

1 Main substrate
5 Mask portion
6 Mask pattern
10 First substrate
20 Second substrate
25 Light-emitting element substrate (laser element substrate)
27 Laser element
29 Laser module
50 Light-emitting device manufacturing apparatus
BS Base substrate
JS Underlying substrate
TS Template substrate
KB Opening portion
LK Low-defect portion

## Claims

1. A manufacturing method for a light-emitting device, the manufacturing method comprising:
preparing a first substrate provided with a plurality of light-emitting bodies;
preparing a second substrate comprising a first bonding portion having conductivity, a first pad portion electrically connected to the first bonding portion, and a first solder regulating portion located between the first bonding portion and the first pad portion, the second substrate comprising a solder formed on the first bonding portion;
bonding a first object selected from the plurality of light-emitting bodies to the second substrate with the solder; and
transferring the first object to the second substrate by separating the first substrate and the second substrate from each other.

2. The manufacturing method for a light-emitting device according to claim 1, wherein
the first solder regulating portion is lower in wettability of the solder than the first bonding portion.

3. The manufacturing method for a light-emitting device according to claim 1 or 2, wherein
the first solder regulating portion is non-conductive.

4. The manufacturing method for a light-emitting device according to claim 1 or 2, wherein
the first solder regulating portion is conductive and is electrically connected to the first bonding portion.

5. The manufacturing method for a light-emitting device according to any one of claims 1 to 4, wherein
the first solder regulating portion is recessed from the first bonding portion.

6. The manufacturing method for a light-emitting device according to claim 5, wherein
the second substrate comprises an underlying substrate, and
the underlying substrate is exposed at the first solder regulating portion.

7. The manufacturing method for a light-emitting device according to any one of claims 1 to 4, wherein
the first solder regulating portion is raised from the first bonding portion.

8. The manufacturing method for a light-emitting device according to any one of claims 1 to 7, wherein
each light-emitting body comprises a first electrode,
the first substrate and second substrate are brought close to each other while at least one of the first substrate and second substrate is heated, and the solder that is melted is brought into contact with a first electrode of the first object selected from the plurality of light-emitting bodies.

9. The manufacturing method for a light-emitting device according to any one of claims 1 to 8, wherein
the first bonding portion and the first pad portion are arranged in a first direction, and
a size of the first pad portion in a second direction orthogonal to the first direction is larger than a size of the first bonding portion.

10. The manufacturing method for a light-emitting device according to any one of claims 1 to 9, wherein
the second substrate comprises one or more bridging portions that electrically connect the first bonding portion and the first pad portion.

11. The manufacturing method for a light-emitting device according to claim 10, wherein
the first bonding portion and the first pad portion are arranged in a first direction, and
a size of the bridging portion in a second direction orthogonal to the first direction is smaller than a size of the first bonding portion and the first pad portion.

12. The manufacturing method for a light-emitting device according to claim 10 or 11, wherein
the bridging portion has a bent shape.

13. The manufacturing method for a light-emitting device according to any one of claims 1 to 12, wherein
the first bonding portion and the solder contain Au.

14. The manufacturing method for a light-emitting device according to claim 3, wherein
the first solder regulating portion comprises a dielectric material.

15. The manufacturing method for a light-emitting device according to claim 4, wherein
the first solder regulating portion contains Pt.

16. The manufacturing method for a light-emitting device according to any one of claims 1 to 15, wherein
the plurality of light-emitting bodies are a plurality of semiconductor laser bodies arranged in a first direction.

17. The manufacturing method for a light-emitting device according to claim 16, wherein
the first object is transferred to the second substrate such that a second direction perpendicular to the first direction and a resonator length direction of the first object coincide with each other.

18. The manufacturing method for a light-emitting device according to claim 17, wherein
the second substrate comprises an underlying substrate,
a recessed portion is formed in the underlying substrate, and
the first object is transferred to the second substrate such that a light-exit end of the first object is located on the recessed portion.

19. The manufacturing method for a light-emitting device according to any one of claims 1 to 18, wherein
the first substrate comprises a base substrate, and
the second substrate comprises an underlying substrate, and
each of the base substrate and the underlying substrate comprises a silicon substrate, or each of the base substrate and the underlying substrate comprises a silicon carbide substrate.

20. The manufacturing method for a light-emitting device according to claim 10, wherein
the first bonding portion and the first pad portion are arranged in a first direction, and
the second substrate comprises two bridging portions arranged in a second direction orthogonal to the first direction, and the first solder regulating portion is located between the two bridging portions.

21. The manufacturing method for a light-emitting device according to claim 10, wherein
in the second substrate, one bridging portion is located between the first bonding portion and the first pad portion arranged in a first direction, and the first solder regulating portion is formed on each of both sides in a second direction orthogonal to the first direction.

22. The manufacturing method for a light-emitting device according to any one of claims 1 to 21, wherein
each light-emitting body comprises a second electrode,
the second substrate comprises a conductive second bonding portion, a second pad portion electrically connected to the second bonding portion, and a second solder regulating portion located between the second bonding portion and the second pad portion, a solder being formed on the second bonding portion, and
the solder that is melted on the first bonding portion is brought into contact with the first electrode of the first object, and the solder that is melted on the second bonding portion is brought into contact with the second electrode of the first object.

23. The manufacturing method for a light-emitting device according to claim 8, wherein
after the solder is melted by heating the second substrate, the solder is solidified by lowering a temperature of the second substrate.

24. The manufacturing method for a light-emitting device according to claim 23, wherein
the first substrate comprises a base substrate, and
a connection portion between the base substrate and each light-emitting body is broken by an external force applied after the solder is solidified, or is broken by itself when the solder is solidified.

25. The manufacturing method for a light-emitting device according to claim 1, further comprising transferring a second object selected from the plurality of light-emitting bodies remaining on the first substrate to a third substrate.

26. The manufacturing method for a light-emitting device according to claim 25, wherein
the first object and the second object are adjacent to each other in the plurality of light-emitting bodies.

27. The manufacturing method for a light-emitting device according to any one of claims 1 to 26, further comprising dividing a light-emitting element substrate, obtained by selectively transferring a first object group comprising the first object to the second substrate, into a plurality of light-emitting element substrates.

28. The manufacturing method for a light-emitting device according to any one of claims 1 to 27, wherein
the plurality of light-emitting bodies are arranged in a first direction, and
a sum of a size of the first bonding portion in the first direction and a size of the first pad portion in the first direction is smaller than a sum of a size of each light-emitting body in the first direction and an interval between adjacent light-emitting bodies.

29. The manufacturing method for a light-emitting device according to any one of claims 1 to 28, wherein
the first bonding portion and the first pad portion are arranged in a first direction, and
a size of the solder in the second direction orthogonal to the first direction is larger than a size of the first solder regulating portion.

30. The manufacturing method for a light-emitting device according to any one of claims 1 to 29, wherein
the first substrate comprises a template substrate comprising a seed region and a growth suppression region, and
the first object is crystalline-bonded to the seed region and overlaps the growth suppression region in a plan view.

31. The manufacturing method for a light-emitting device according to claim 30, wherein
a width direction is a direction in which the plurality of light-emitting bodies are arranged, and
a combined width of the first object and the seed region is equal to or less than 1/5 of a width of the first object.

32. A light-emitting device manufacturing apparatus that performs each step described in claim 1.

33. A laser element substrate comprising an underlying substrate and a plurality of semiconductor laser bodies, wherein
a first bonding portion having conductivity, a first pad portion electrically connected to the first bonding portion, and a first solder regulating portion located between the first bonding portion and the first pad portion are located on the underlying substrate,
the first bonding portion and the first pad portion are arranged in a first direction, each of the semiconductor laser bodies is soldered to the first bonding portion such that a resonator length direction is orthogonal to the first direction, and
the underlying substrate comprises a recessed portion located below a light-exit end of each of the semiconductor laser bodies.
